# EUROPEAN PATENT SPECIFICATION

(11) **EP 2 464 022 B1**
(45) Date of publication and mention of the grant of the patent: **23.04.2014**
(21) Application number: 10194159.9
(22) Date of filing: 08.12.2010
(51) Int. Cl.: H03M 13/41

(54) **Decoding tail-biting convolutional codes**
Dekodierung von Tail-biting-Faltungskodes
Décodage de codes convolutifs circulaires

(43) Date of publication of application: 13.06.2012
(73) Proprietor: BlackBerry Limited, Waterloo, ON N2K 0A7 (CA)
(72) Inventor: Wu, Huan, Kanata Ontario K2K 3K1 (CA); Simmons, Sean Bartholomew, Waterloo Ontario N2L 3W8 (CA)
(74) Representative: Finnie, Peter John

(56) References cited:
- US-A1- 2006 242 531
- FOSSORIER M P C ET AL: "Two decoding algorithms for tailbiting codes", IEEE TRANSACTIONS ON COMMUNICATIONS, IEEE SERVICE CENTER, PISCATAWAY, NJ. USA, vol. 51, no. 10, 1 October 2003 (2003-10-01), pages 1658-1665, XP011102444, ISSN: 0090-6778, DOI: DOI:10.1109/TCOMM.2003.818084
- TSAO-TSEN CHEN ET AL: "Reduced-complexity wrap-around Viterbi algorithm for decoding tail-biting convolutional codes", PROC. 14TH EUROPEAN WIRELESS CONFERENCE 2008 (EW 2008), IEEE, PISCATAWAY, NJ, USA, 22 June 2008 (2008-06-22), pages 1-6, XP031320010, ISBN: 978-3-8007-3102-2
- ZHANG MIN ET AL: "Research on An-Based Decode of Tail-Biting Convolutional Codes and Their Performance Analyses Used in LTE System", PROC. INTERNATIONAL FORUM ON INFORMATION TECHNOLOGY AND APPLICATIONS 2009 (IFITA '09), IEEE, PISCATAWAY, NJ, USA, 15 May 2009 (2009-05-15), pages 303-306, XP031525040, ISBN: 978-0-7695-3600-2
- COX R V ET AL: "AN EFFICIENT ADAPTIVE CIRCULAR VITERBI ALGORITHM FOR DECODING GENERALIZED TAILBITING CONVOLUTIONAL CODES", IEEE TRANSACTIONS ON VEHICULAR TECHNOLOGY, IEEE SERVICE CENTER, PISCATAWAY, NJ, US, vol. 43, no. 1, 1 February 1994 (1994-02-01), pages 57-68, XP000450947, ISSN: 0018-9545, DOI: DOI:10.1109/25.282266

## Description

### BACKGROUND

As used herein, the terms "user equipment" and "UE" might in some cases refer to mobile devices such as mobile telephones, mobile devices, personal digital assistants, handheld or laptop computers, and similar devices that have telecommunications capabilities. Such a UE might consist of a UE and its associated removable memory module, such as but not limited to a Universal Integrated Circuit Card (UICC) that includes a Subscriber Identity Module (SIM) application, a Universal Subscriber Identity Module (USIM) application, or a Removable User Identity Module (R-UIM) application. Alternatively, such a UE might consist of the device itself without such a module. In other cases, the term "UE" might refer to devices that have similar capabilities but that are not transportable, such as desktop computers, set-top boxes, or network appliances. The term "UE" can also refer to any hardware or software component that can terminate a communications session for a user. Also, the terms "user equipment," "UE," "user agent," "UA," "user device" and "user node" might be used synonymously herein.

Tsao-Tsen Chen et al. relates to reduced-complexity wrap-around Viterbi codes for decoding tail-biting convolutional codes. Generally, the document suggests a plurality of algorithms to decrease the number of decoding iterations and memory consumption. A first algorithm may use a best path at iteration i and a best tail-biting path up to iteration i to test whether a termination condition is satisfied. A second algorithm may use a best tail-biting path at iteration i, instead of up to the best tailbiting path up to iteration i.

Zhang Min et al. relates to tail-biting convolutional coding in LTE communications systems. For example, the document presents three Viterbi algorithm schemes: a wrap-around Viterbi algorithm, a bidirectional Viterbi algorithm and a double trace-back Viterbi algorithm. The document generally discusses bit-error rate performances for all three algorithms.

US 2006/0242531 A1 relates to a method for decoding tail-biting convolutional codes. For example, the document presents a trace-back process that is performed from an ending state of the trellis diagram at a first time instance to a first state where all surviving paths converge at a second time instance. The document also discloses the calculation of backward Viterbi metrics for a predetermined period of time, from the first state at a second time instance to a second state at a third time instance.

Cox R. V. et al. relates to an adaptive circular Viterbi algorithm for generalized tailbiting convolutional codes. For example, the document suggests replicating the received blocks and performing continuous Vierbi decoding by starting simultaneously in all states. Further, the document proposes to end the decoding process, either adaptively or with a fixed length, and presents three different adaptive stopping rules.

According to a first aspect, there is provided a user equipment as set out in claim 1.

According to a second aspect, there is provided a base station as set out in claim 2.

According to a third aspect, there is provided a method as set out in claim 3.

According to a fourth aspect, there is provided a computer readable medium as set out in claim 14.

### BRIEF DESCRIPTION OF THE DRAWINGS

For a more complete understanding of this disclosure, reference is now made to the following brief description, taken in connection with the accompanying drawings and detailed description, wherein like reference numerals represent like parts.
Figure 1 is a schematic diagram of a communications system that allows a UE to communicate with other network components and/or devices according to an embodiment of the disclosure.
Figure 2 illustrates a graphical representation of computed paths to decode tail-biting convolution codes (TBCCs) according to an embodiment of the disclosure.
Figure 3 is a flowchart of a method for decoding TBCCs according to an embodiment of the disclosure.
Figure 4 illustrates an example chart for block error rates and uncoded bit error rates achieved using a TBCC decoding algorithm according to an embodiment of the disclosure.
Figure 5 illustrates another example chart for block error rates and uncoded bit error rates achieved using a TBCC decoding algorithm according to an embodiment of the disclosure.
Figure 6 illustrates another example chart for block error rates and uncoded bit error rates achieved using a TBCC decoding algorithm according to an embodiment of the disclosure.
Figure 7 illustrates a processor and related components suitable for implementing the several embodiments of the present disclosure.

### DETAILED DESCRIPTION

It should be understood at the outset that although illustrative implementations of one or more embodiments of the present disclosure are provided below, the disclosed systems and/or methods may be implemented using any number of techniques, whether currently known or in existence. The disclosure should in no way be limited to the illustrative implementations, drawings, and techniques illustrated below, including the exemplary designs and implementations illustrated and described herein, but may be modified within the scope of the appended claims along with their full scope of equivalents.

TBCCs are used in forward error correction (FEC) schemes for control channels, such as a Physical Control Channel (PDCCH), in many wireless communications systems. For example, the TBCCs may be used in the Third Generation Partnership Project (3GPP) standard, including Global System for Mobile Communications (GSM), General packet radio service (GPRS), IS-54, Enhanced Data rates for GSM Evolution (EDGE), worldwide interoperability for microwave access (WiMAX), and long-term evolution (LTE) mobile communications systems. In convolutional coding, an encoder receives a stream of x bits and maps them into an output stream of y bits by operating on one or multiple bits at a time (x and y are integers). The encoder uses each received bit and a number of z bits retained in "memory", also referred to as a "state", to output bits and to update the state in memory for processing the next received bit. The efficiency or data rate of a convolutional code is measured by the ratio of the quantity of bits in the input stream, x, to the quantity of bits in the output stream, y. The ratio x/y is referred to as the coding rate and the state bit size z is referred to as the constraint length. Typically, the values of x, y, and z may range from 1 to 2, 2 to 3, and 4 to 7, respectively.

The output stream may then be received and used at a decoder to retrieve the original input stream or a close match to the input stream to the encoder. The transitions or path between the states of the encoder may be tracked using the output stream in a graphical representation referred to as a trellis. If a path in the trellis corresponds to a TBCC, then its beginning state is equal to its ending state. The decoder may use a TBCC decoding algorithm to retrieve a match to the original input stream that corresponds to the most likelihood path (MLP) in the trellis. Many algorithms have been proposed for decoding a TBCC that include using Viterbi algorithms (VAs), such as a wrap-around Viterbi algorithm (WAVA) that provides a near-maximum likelihood (ML) match to the input stream with relatively low complexity. The TBCC may be decoded by implementing a plurality of iterations or Viterbi trials in an attempt to find a ML tail-biting path (MLTBP) in the trellis. The WAVA and other decoding algorithms may use different early termination conditions, limited number of iterations, or both to reduce the amount of time/memory needed to decode the TBCCs.

Disclosed herein is a system and method for decoding TBCCs in received bit streams, such as in control/data channels in radio access network (RANs). In some embodiments, the proposed TBCC decoding method or algorithm may have improved efficiency, for example in comparison to other TBCC decoding algorithms. In some embodiments, the efficiency may be improved using an early termination condition that reduces the iterations and/or the steps per iteration and hence reduce the time/memory needed for decoding, e.g. in comparison to the WAVA. The TBCC decoding scheme may also provide an input stream at the decoder that is sufficiently close to the original input stream at the encoder and have comparable accuracy with respect to other TBCC decoding algorithms.

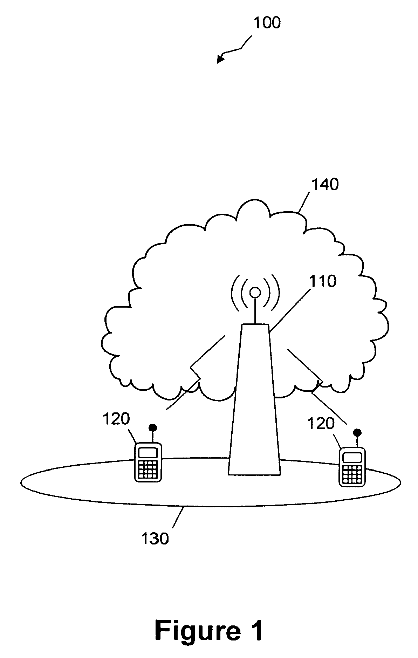

Figure 1 illustrates an embodiment of a RAN 100, which may be a LTE or LTE-Advanced (LTE-A), as described in 3GPP, or other well known or after developed networks. In this example, an LTE or LTE-A system might include an Evolved Universal Terrestrial Radio Access Network (E-UTRAN) node B (or eNB), a wireless access point, or a similar component rather than a traditional base station. Figure 1 is exemplary and may have other components or arrangements in other embodiments. In an embodiment, the RAN 100 may comprise at least one access device 110 and at least one UE 120, which may be both located within a cell 130.

As used herein, the term "access device" refers to any component of the wireless network, such as a traditional base station, a wireless access point, or an LTE or LTE-A node B or eNB, that creates a geographical area of reception and transmission coverage allowing a UE 120 or a relay node (not shown) to access or communicate with other components in a telecommunications system, such as second UE 120. In this document, the term "access node" and "access device" may be used interchangeably, but it is understood that an access node may comprise a plurality of hardware and software components.

The access device 110 may communicate with any UE 120 within the same cell 130, directly via a direct link, such as in a UTRAN. The cell 130 may be a geographical area of reception and transmission coverage. For instance, the direct link may be a point-to-point link established between the access device 110 and the UE 120 and used to transmit and receive signals between the two. Alternatively, the access devices 110 may communicate with any UE 120 in the same cell 130 over shared links, such as in an E-UTRAN. For instance, the shared links may comprise an uplink shared channel and a downlink shared channel. Additionally, the access devices 110 may communicate with other components or devices to provide for the components of the RAN 100 access to any other network 140, for instance using similar or different network protocols or technologies. In an embodiment, the UEs 120 may move about between different cells 130 and their communications may be handed-over between the different cells 130, where the UEs 120 may communicate with different access devices 110.

In some embodiments, the UEs 120 may communicate via a combination of wireless and wired networks. The networks may include the RAN 100, a Wireless LAN (WLAN) network, an Ethernet based network, an Internet Protocol (IP) based network, a Digital Subscriber Line (DSL) network, an Optical communications network, and/or any other wireless and wired networks that may be used to exchange communications between the UEs 120. The communications between the UEs 120 may comprise voice and/or video calls, emails, text/media messages (e.g. using SMS or Multimedia Messaging Service (MMS)), and/or any other data or message exchanges.

The communications between the access devices 110 and the UEs 120 may comprise a plurality of control and/or data channels, which may include a PDCCH, a physical downlink dedicated channel (PDDCH), an uplink dedicated channel (PUDCH), a physical uplink control channel (PUCCH), or combinations thereof. Any of the channels may be used to carry bit streams between the access device(s) 110 and the UE(s) 120. The bit streams may comprise a plurality of encoded bits, such as FEC codes. The bit streams or FEC codes may comprise TBCCs that correspond to input streams encoded at a transmitter, for example in a base station 110. The TBCCs may then be received in a receiver, for example in a UE 120, and decoded to retrieve the original input stream with acceptable amount of errors. In another embodiment, the TBCCs may be encoded at the UE 120 and decoded at the base station 110.

In an embodiment, the UE 120 or the access device 110 may comprise a receiver/decoder that is configured to implement a TBCC decoding algorithm to decode a TBCC in a received output stream from a transmitter/encoder. The TBCC decoding algorithm may implement a plurality of iterations or Viterbi trials to compute a plurality of paths (or sub-trellises), e.g. in a trellis, and find a ML tail-biting path (MLTBP) or a ML path from the computed paths that best matches the encoding states of the transmitter/encoder. The paths may be computed using the received TBCC bits. The paths computed during each iteration correspond to all the possible starting states used at the transmitter/encoder. The states of each computed path may be examined in turn using a trace-back procedure from the path ending state to its starting state, until all the computed paths are examined or an early termination condition is met.

The trace-backs and iterations may be ended when a MLTBP or a ML path is selected. The states in the MLTBP or the ML path may then be used to reconstruct or estimate with sufficient accuracy the original input stream at the transmitter/encoder (before encoding). The early termination condition may be based on a trace-back convergence check (TCC), where each of the computed paths in an iteration may be checked, in some order, to determine if the trace-backs may be terminated early before examining all the computed paths, as described in detail below. As such, this TBCC decoding algorithm may implement fewer trace -backs and/or iterations than other TBCC decoding algorithms, such as the WAVA. The proposed TBCC decoding algorithm may also estimate the original input stream at about the same accuracy as other TBCC algorithms. Reducing the number of trace-backs and/or iterations in the algorithm may reduce the amount of memory and/or time needed to decode the TBCCs and also reduce the complexity of implementation.

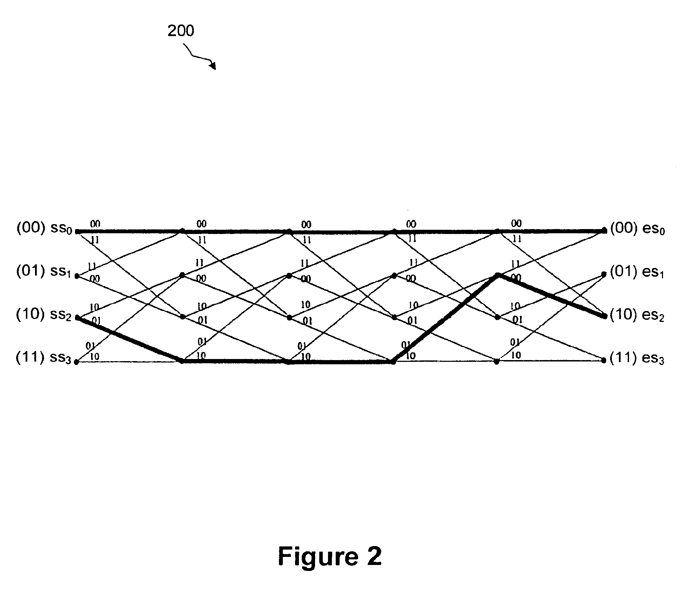

Figure 2 illustrates an example of a trellis 200 that may comprise a plurality of computed paths corresponding to the different possible starting of an encoder. The trellis 200 is a graphical representation of the path computation process and may or may not be actually or explicitly used in the implementation of the TBCC decoding algorithm. For instance, instead of using the graphical representation of the trellis, the paths may be computed and trace-backed by storing the values/parameters associated with the paths in the UE's memory or data storage medium.

The trellis 200 may comprise M starting states and equally M ending states. For example, there may be four starting states (M = 4) that include, ss₀ = 00, ss₁ = 01, ss₂ = 10, and ss₃ = 11, and similarly four ending states that include, es₀ = 00, es₁ = 01, es₂ = 10, and es₃ = 11. During the TBCC decoding algorithm, one path may be computed for each starting state from a plurality of possible paths that may be found in the trellis. For example, the computed path for each starting state may have the highest value state metric among the possible paths. As such, the trellis may comprise M computed paths (or subtrellises) in the trellis. In Figure 2, the bold line paths represent two of the computed paths from a plurality of possible paths. The two computed paths are tail-biting paths that link the starting states ss₀ and ss₃ to their equal ending states es₀ and es₃, respectively.

The paths for each starting state may be computed or updated at each iteration using a VA. As such, the number of implemented VAs may be equal to the number of iterations. Further, each VA that is used to compute or update the M paths may implement N Viterbi updates (or decoding stages) to transition between each two states in the computed paths. The number of transitions between the states may be proportional to the number of bits in the received TBCC at the receiver/decoder and reflects the states used in the transmitter/encoder. For example, as shown in Figure 2, there may be five state transitions or sections in each path between its starting and ending states, which may correspond to five bits in the TBCC. The complexity of the TBCC encoding algorithm may be proportional to the number of iterations (I), the number of states in VA per iteration (M), the number of trace-backs per iteration (T), and the number of Viterbi updates (N) per iteration, e.g. Ix(MxN+TxN),. Thus, the complexity and the amount of time/memory needed for the TBCC decoding algorithm may increase as the number of possible iterations, trace-backs, starting states and/or the quantity of bits in the TBCC increase. For this reason, reducing the number of trace-backs and/or iterations, by using an early termination condition, becomes more critical for longer TBCCs that are based on more states in the transmitter/encoder.

Specifically, the TBCC decoding algorithm may use a TCC early termination condition to reduce the number of trace-backs and/or iterations. After an iteration, the M updated paths (for the M starting states) may be sorted in a descending order of their calculated state metric values. For instance, using correlation as metrics in a VA, the M updated paths may be ordered from the updated path that has the highest value state metric to the updated path that has the lowest value state metric. The highest value state metric may indicate that the corresponding updated path is a ML match to the actual states used in the transmitter/encoder. A path trace-back may then be used to examine the state transitions of the first updated path, e.g. in the order from the ending state to the starting state. If the first updated path is a tail-biting path, i.e. has the same or equal starting and ending states, then the first updated path may be the MLTBP. In this case, the remaining updated paths may be ignored and no further trace-backs and iterations are performed. The first updated path may be used to retrieve the original bits of the input stream before encoding.

If the first updated path is not a tail-biting path, then each next updated path with the next highest value state metric may be traced back in tum, until an updated tail-biting path is found or a TCC condition fails. The TCC condition fails if the starting state of the next updated path is not equal to the starting state of the first updated path. The TCC condition may be checked in the iterations that succeed the first iteration. As such, if a tail-biting path is found before examining all the remaining paths, then the remaining computed paths may be ignored and no further trace-backs and iterations are performed. The tail-biting path may then be used to retrieve the bits of the input stream. Alternatively, if the TCC condition fails before examining all the remaining paths, then the remaining updated paths may be ignored and no further trace-backs are performed. The starting states of all the updated paths may then be replaced with the corresponding ending states of the updated paths and the TBCC decoding algorithm may proceed to the next iteration, where the M paths may be again updated and reexamined for early termination in the same manner above.

In other embodiments, the computed paths may be ordered and processed for early termination in any other order than described above. For instance, using Euclidean distance as the metrics in a VA, the computed paths may be ordered in an ascending order of their calculated state metric values, where the lowest value state metric value may indicate that the corresponding computed path is a ML match to the actual states used in the transmitter/encoder.

The TBCC decoding algorithm that uses a TCC early termination condition similar to that described above may be referred to herein as a WAVA-TCC. The WAVA-TCC may comprise at least some of the following instructions or similar instructions:
1) Start with the VA with all state metrics set to zero (equal likelihood). Set the iteration
   index i = 0.
2) At the end of a VA iteration, i = i + 1; sort the ending state metrics in descending order. Do one trace-back from the ending state (es₀) of the top state metrics to find the starting state (ss₀). If ss₀ == es₀ (i.e., it is the ML tail-biting path), go to step 5). Otherwise continue to next step.
3) If i > 1, continue the trace-backs from the ending states (esₖ) following those of the top state metrics to find the starting state (ssₖ), k = 1, 2, ... M-1, M is the number of states of the trellis. If ssₖ ∼= ss₀ and i < Imax (TCC fails), then stop trace-back and go to step 4). Otherwise continue trace-back until a tail-biting path is found (ssₖ == esₖ) or all the trace-backs are exhausted. If a tail-biting path is found, go to step 5). Otherwise continue to next step.
4) If i < Imax, update the starting state metrics with the corresponding ending state metrics (wrap-around) and go to step 2). Otherwise continue to next step.
5) Output the decoded bits from a tail-biting path if there is one. Otherwise output the decoded bits from the ML path, i.e., the path with the maximum ending state metrics.

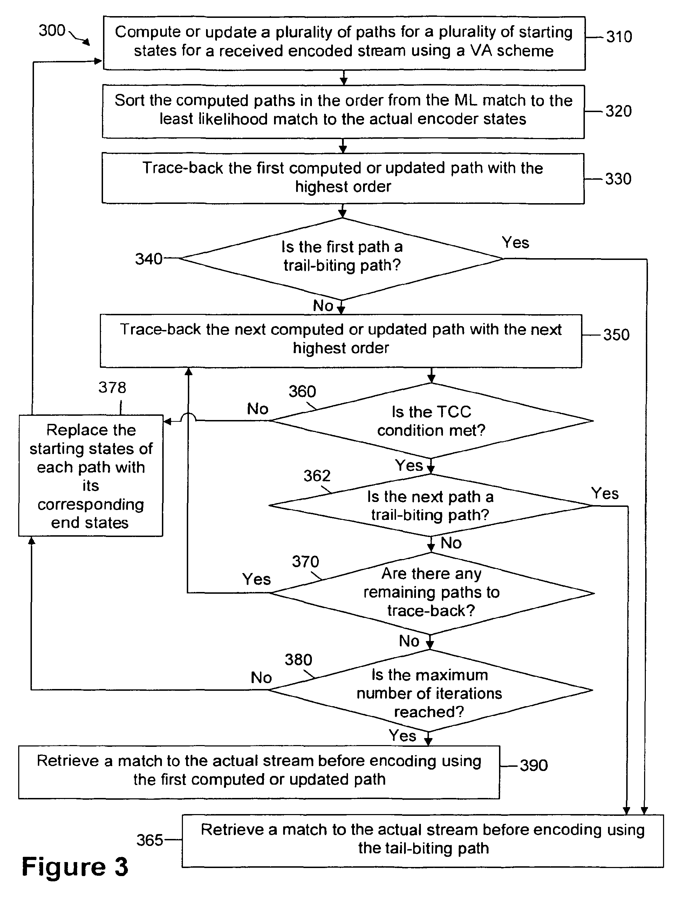

Figure 3 illustrates an embodiment of a method 300 for decoding TBCCs in the RAN 100. For instance, the method 300 may be implemented by a UE 120 or a processor at the UE 120 to decode a TBCC in a PDCCH. The method 300 may use the TCC condition to early terminate trace-backs per iteration and may correspond to the WAVA-TCC described above. At block 310, a plurality of paths for a plurality of starting states may be computed or updated for a received encoded stream using a VA scheme. For example, the UE 120 may use a VA scheme to process the received TBCC in a bit stream in the PDCCH and thus obtain a plurality of computed paths that correspond to all the possible starting states used at the transmitter/encoder. The UE 110 may implement a VA to compute each of the paths that have a different starting state in a first or initial iteration of the TBCC decoding algorithm or to update each of the paths in a subsequent iteration.

At block 320, the computed paths may be sorted in the order from the ML match to the least likelihood match to the actual encoder states. For example, when correlation metrics is used in a VA, the UE 110 may sort the computed paths in the order from the path that has the highest value state metric to the path with the lowest value state metric, where the highest value state metric indicates the ML matched path. Alternatively, when Euclidean distance metrics is used in a VA, the UE 110 may sort the computed paths in the order from the path that has the lowest value state metric to the path with the highest value state metric, where the lowest value state metric indicates the ML matched path.

At block 330, the first computed or updated path with the highest order may be traced back. The U E 110 may trace-back the first computed or updated path to examine the ending and starting states of the path. At block 340, the method 300 may determine whether the first path is a trail-biting path. The first path may be a tail-biting path if its starting and ending states are the same or equal. If the condition in block 340 is satisfied, the method 300 may proceed to block 365. Otherwise, the method 300 may proceed to block 350.

At block 350, the next computed or updated path with the next highest order may be traced back. The UE 110 may trace-back the next highest order computed or updated path that has the next highest value state metric to examine the ending and starting states of the path. At block 360, the method 300 may determine whether the TCC condition is met, i.e. whether the starting state of the next computed or updated path is equal to the starting state of the first computed or updated path. If the TCC condition is met, the method 300 may proceed to block 362. Otherwise, the method 300 may proceed to block 382. In an embodiment, the TCC condition may not be checked during the first iteration of the TBCC decoding algorithm to allow only one trace-back of the first ML path during the first iteration. At block 362, the method 300 may determine whether the next path, which satisfies the TCC condition, is a trail-biting path. If the condition in block 362 is met, then the method 300 may proceed to block 365. Otherwise, the method 300 may proceed to block 370. At block 365, a match to the original bit stream before encoding may be retrieved using the tail-biting path, i.e. the MLTBP path. The tail-biting path may be the first computed or updated path or any of the next computed or updated paths that satisfies the TCC condition. The UE 110 may use the transitions between the states of the MLTBP to reconstruct a ML match to the TBCC in the original bit stream before encoding.

Alternatively, at block 370, the method 300 may determine whether there are any remaining paths to trace-back. The method 300 may return to block 350 if there are any remaining paths to trace-back. If all the computed or updated paths are already traced back and the TCC condition is not satisfied, the method 300 may proceed to block 380. At block 380, the method 300 may determine if the maximum number of iterations is reached. The maximum number of iterations may be set before implementation to restrict the memory/time usage of the UE 110. The maximum number of iterations may also be adjusted based on the channel and/or encoding conditions. If the condition in block 380 is not met, the method 300 may proceed to block 382. Otherwise, the method 300 may proceed to block 390.

At block 382, the starting states of each path may be replaced with its corresponding ending state. The method 300 may then return to block 310 to update the paths and subsequently trace-back the paths to find a tail-biting path, as described above. Alternatively, at block 390, a match to the original bit stream before encoding may be retrieved using the first computed or updated path. At this point, the first computed or updated path may not be a tail-biting path but may be the ML path with the highest order and therefore the ML match to the actual encoder states. The UE 120 may use the transitions between the states of the ML path to reconstruct a ML match to the original bit stream before encoding.

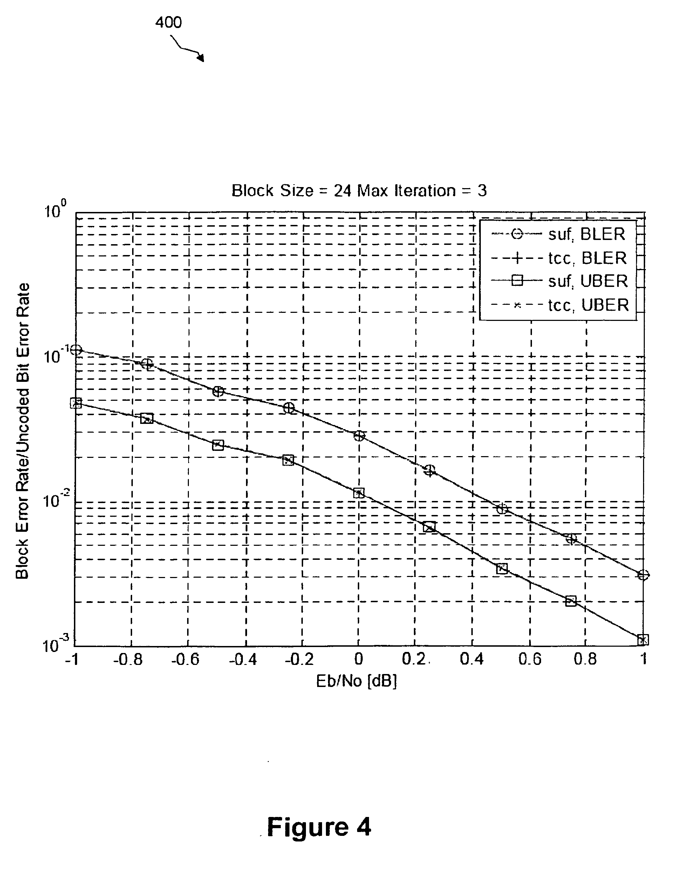

Figure 4 illustrates a chart that shows an example of block error rates and uncoded bit error rates achieved using the WAVA-TCC and using a WAVA that implements a sufficient termination condition to terminate early the decoding scheme. To distinguish the two decoding algorithms, the WAVA is referred to herein as the WAVA-SUF (WAVA with sufficient termination condition). The WAVA-SUF scheme is described in detail in a publication by Rose Y. Shao, et al., entitled "Two Decoding Algorithms for Tailbiting Codes", in the Institute of Electrical and Electronics Engineers (IEEE) Transactions on Communications, Vol. 51, No. 10, October 2003, pp. 1658-1665. The WAVA-SUF may use an early termination condition to reduce the number of iterations that is different than the TCC condition described herein and that does not reduce or limit the trace-backs per iteration.

The rates shown are obtained using simulations for a plurality of TBCCs defined in 3GPP LTE. The TBCCs were generated using a constraint length z = 7, a coding rate x/y = 1/3, and the generator polynomials G₀ = 133*_{O}*, G₁ = 171*_{O}*, and G₀ = 165*_{O}*. The results are shown for a data block size equal to 24 blocks, which corresponds to one possible downlink control information format. The data corresponds to a signal that is modulated using Binary phase-shift keying (BPSK) at the transmitter and contaminated by additive white Gaussian noise (AWGN) at the receiver.

The resulting block error rates and uncoded bit error rates at the receiver are plotted in the figure vs. a range of signal-to-noise ratio (SNR) values in decibel (dB). In Figure 4, the block error rates are labeled BLER, the uncoded bit error rates are labeled UBER, and the SNR values are labeled Eb/No and range from -1 to 1. Each point (i.e. BLER or UBER value) in the figure is obtained using at least 300 block errors. As shown, the BLER values and similarly the UBER values obtained using both WAVA-SUF and WAVA-TCC substantially overlap. The overlap in the BLER values and the UDER values between the two decoding algorithms shows that the WAVA-TCC may have about the same or comparable accuracy of the WAVE-SUF in detecting and decoding the TBCCs.

Additionally, Table 1 below lists the average number of iterations and the average number of trace-backs per iteration for both the WAVA-TCC and WAVA-SUF algorithms to decode the TBCCs. Specifically, the average number of iterations and the average number of trace-backs per iteration are shown for three points in Figure 4, at Eb/No = -1, Eb/No = 0, and Eb/No = 1. Table 1 shows that the WAVA-TCC may implement about 6 to 7 times less trace-backs per iteration than the WAVA-SUF, for all three points shown. The number of iterations in the case of the WAVA-TCC may also be less than the number of iterations in the WAVA-SUF for all three points.

**Table 1: Comparison of average iterations and trace-backs per iteration for block size = 24.**

| block size = 24 | average iterations | | average trace-backs per iteration | |
|---|---|---|---|---|
| Eb/No (dB) | SUF | TCC | SUF | TCC |
| -1.0 | 1.69 | 1.60 | 19.24 | 3.20 |
| 0 | 1.38 | 1.32 | 12.47 | 1.67 |
| 1.0 | 1.17 | 1.15 | 6.71 | 1.15 |

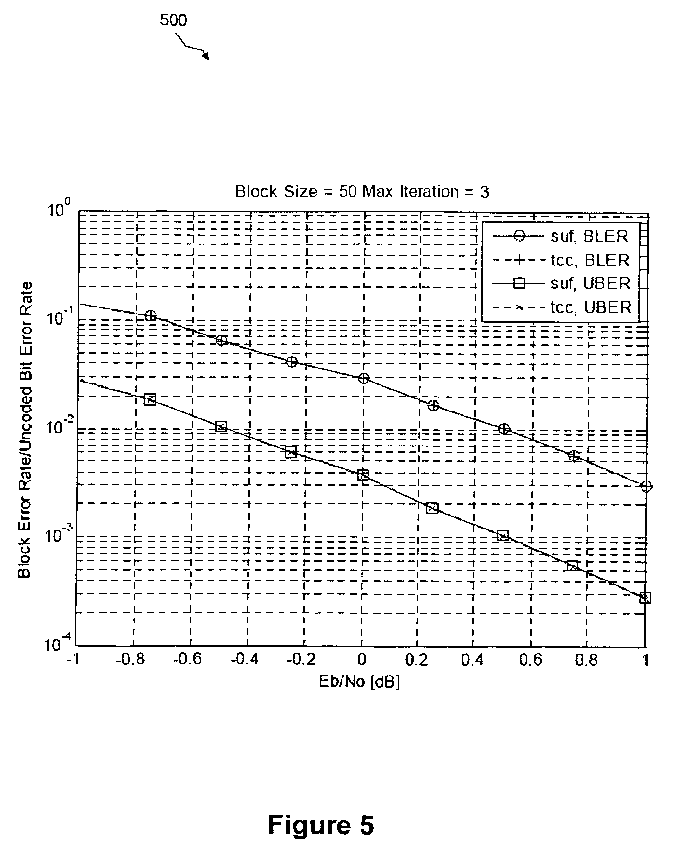

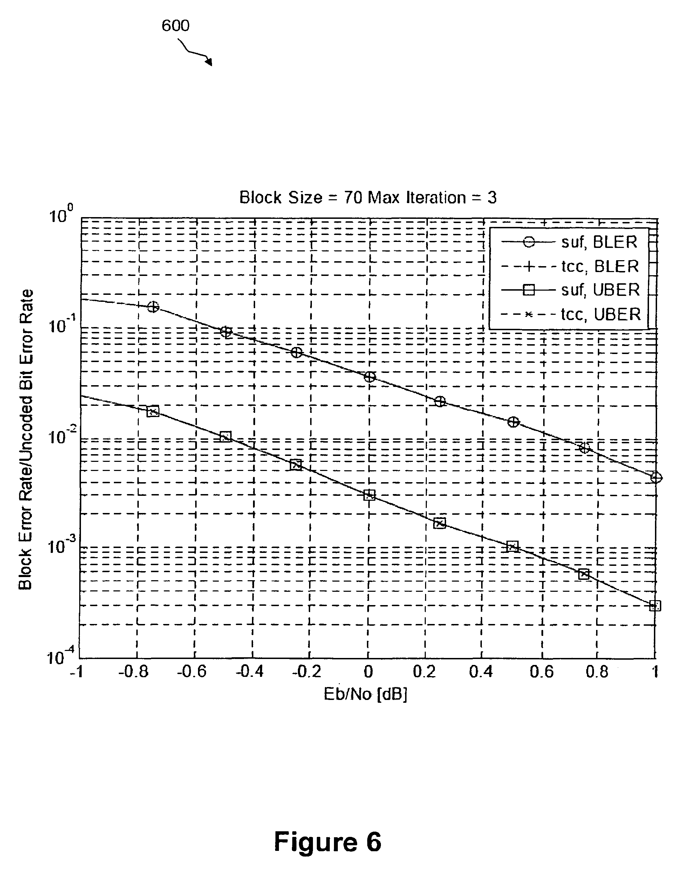

Similarly, Figure 5 and Figure 6 illustrate two additional charts that show two more examples of block error rates and uncoded bit error rates achieved using the WAVA-TCC and the WAVA-SUF. The results shown in Figure 5 and Figure 6 are obtained using the same transmission conditions described above with the difference that the data block sizes in Figure 5 and Figure 6 are equal to 50 bits and 70 bits, respectively. As in the case of Figure 4, both BLER values and the UBER values obtained using WAVA-SUF and WAVA-TCC substantially overlap, which indicates that the WAVA-TCC may have about the same or comparable accuracy of the WAVE-SUF regardless of at least block sizes up to 70 bits. Such quantity of block sizes may represent relatively short codes or TBCCs, but may be suitable for control channel data, such as the PDCCH.

Table 2 and Table 3 below also list the average number of iterations and the average number of trace-backs per iteration for both the WAVA-TCC and WAVA-SUF algorithms for the data in Figure 5 and Figure 6, respectively. Similar to Table 1, Table 2 and Table 3 also show that the WAVA-TCC may implement less trace-backs per iteration and less iterations than the WAVA-SUF for the data block sizes 50 and 70, respectively. Although, the results above are shown for data block sizes up to about 70 bits, the WAVA-TCC may still provide comparable accuracy to the WAVA-SUF, and similar decoding algorithms, for any relatively short or large TBCCs with less trace-backs per iteration and/or less iterations during the decoding process.

**Table 2: Comparison of average iterations and trace-backs per iteration for block size = 50.**

| block size = 24 | average iterations | | average trace-backs per iteration | |
|---|---|---|---|---|
| Eb/No (dB) | SUF | TCC | SUF | TCC |
| -1.0 | 1.68 | 1.52 | 19.04 | 2.20 |
| 0 | 1.36 | 1.29 | 11.99 | 1.36 |
| 1.0 | 1.17 | 1.14 | 6.84 | 1.11 |

**Table 3: Comparison of average iterations and trace-backs per iteration for block size = 70.**

| block size = 24 | average iterations | | average trace-backs per iteration | |
|---|---|---|---|---|
| Eb/No (dB) | SUF | TCC | SUF | TCC |
| -1.0 | 1.67 | 1.50 | 18.26 | 1.89 |
| 0 | 1.37 | 1.29 | 11.88 | 1.32 |
| 1.0 | 1.17 | 1.14 | 6.77 | 1.11 |

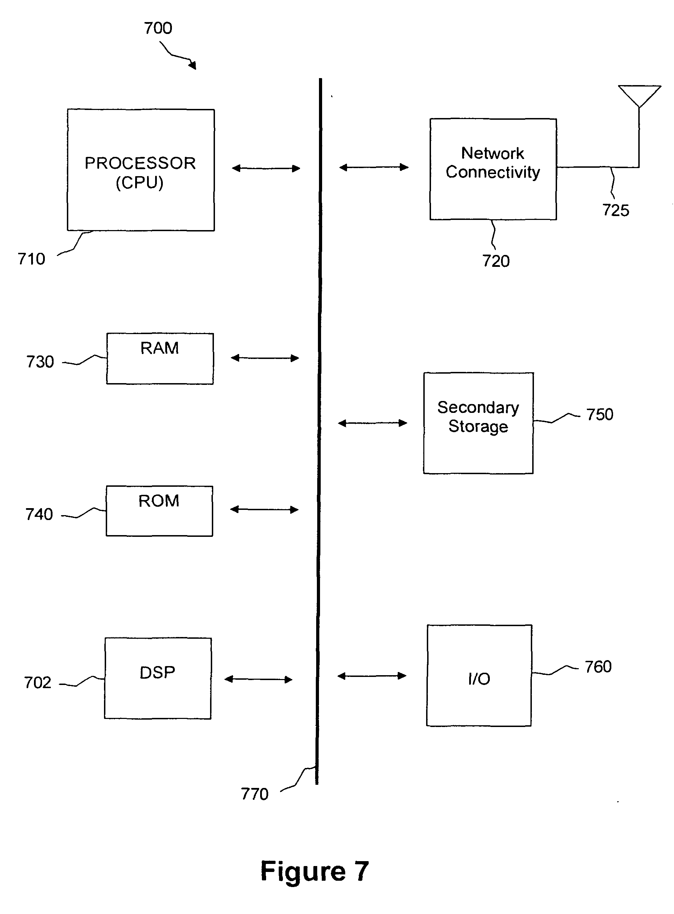

The UE 120 and other components described above might include a processing component that is capable of executing instructions related to the actions described above. Figure 7 illustrates an example of a system 700 that includes a processing component 710 suitable for implementing one or more embodiments disclosed herein. In addition to the processor 710 (which may be referred to as a central processor unit or CPU), the system 700 might include network connectivity devices 720, random access memory (RAM) 730, read only memory (ROM) 740, secondary storage 750, and input/output (I/O) devices 760. These components might communicate with one another via a bus 770. In some cases, some of these components may not be present or may be combined in various combinations with one another or with other components not shown. These components might be located in a single physical entity or in more than one physical entity. Any actions described herein as being taken by the processor 710 might be taken by the processor 710 alone or by the processor 710 in conjunction with one or more components shown or not shown in the drawing, such as a digital signal processor (DSP) 702. Although the DSP 702 is shown as a separate component, the DSP 702 might be incorporated into the processor 710.

The processor 710 executes instructions, codes, computer programs, or scripts that it might access from the network connectivity devices 720, RAM 730, ROM 740, or secondary storage 750 (which might include various disk-based systems such as hard disk, floppy disk, or optical disk). While only one CPU 710 is shown, multiple processors may be present. Thus, while instructions may be discussed as being executed by a processor, the instructions may be executed simultaneously, serially, or otherwise by one or multiple processors. The processor 710 may be implemented as one or more CPU chips.

The network connectivity devices 720 may take the form of modems, modem banks, Ethernet devices, universal serial bus (USB) interface devices, serial interfaces, token ring devices, fiber distributed data interface (FDDI) devices, wireless local area network (WLAN) devices, radio transceiver devices such as code division multiple access (CDMA) devices, GSM radio transceiver devices, WiMAX devices, and/or other well-known devices for connecting to networks. These network connectivity devices 720 may enable the processor 710 to communicate with the Internet or one or more telecommunications networks or other networks from which the processor 710 might receive information or to which the processor 710 might output information. The network connectivity devices 720 might also include one or more transceiver components 725 capable of transmitting and/or receiving data wirelessly.

The RAM 730 might be used to store volatile data and perhaps to store instructions that are executed by the processor 710. The ROM 740 is a non-volatile memory device that typically has a smaller memory capacity than the memory capacity of the secondary storage 750. ROM 740 might be used to store instructions and perhaps data that are read during execution of the instructions. Access to both RAM 730 and ROM 740 is typically faster than to secondary storage 750. The secondary storage 750 is typically comprised of one or more disk drives or tape drives and might be used for non-volatile storage of data or as an over-flow data storage device if RAM 730 is not large enough to hold all working data. Secondary storage 750 may be used to store programs that are loaded into RAM 730 when such programs are selected for execution.

The I/O devices 760 may include liquid crystal displays (LCDs), touch screen displays, keyboards, keypads, switches, dials, mice, track balls, voice recognizers, card readers, paper tape readers, printers, video monitors, or other well-known input devices. Also, the transceiver 725 might be considered to be a component of the I/O devices 760 instead of or in addition to being a component of the network connectivity devices 720.

Various combinations of the components of the system 700, including memory, hardware, firmware, software or others may be referred to herein as a "component".

In an embodiment a UE is provided. The UE comprising at least one component configured to decode a TBCC by calculating a plurality of paths that correspond to a plurality of encoder starting states and trace back at least one of the calculated paths per at least one iteration until a TCC condition fails, wherein the TCC condition fails if a starting state of a first traced back path among the calculated paths is not equal to a starting state of a subsequent traced back path.

In another embodiment an access device is provided. The access device comprising at least one component configured to decode a TBCC by calculating a plurality of paths that correspond to a plurality encoder starting states in at least one iteration and trace back at least one of the calculated paths per at least one iteration until a TCC condition fails, wherein the TCC condition fails if a starting state of a first traced back path among the calculated paths is not equal to a starting state of a subsequent traced back path.

In another embodiment, a method implemented on a device is provided. The method comprising receiving TBCC, calculating a plurality of paths that correspond to a plurality of encoder starting states of the TBCC in at least one iteration, and tracing back at least one of the calculated paths per at least one iteration until a TCC condition fails, wherein the TCC condition fails if a starting state of a first traced back path among the calculated paths is not equal to a starting state of a subsequent traced back path.

The method, wherein the device is one of a UE, an access device, or any network connectivity device.

While several embodiments have been provided in the present disclosure, it should be understood that the disclosed systems and methods may be embodied in many other specific forms. The present examples are to be considered as illustrative and not restrictive, and the intention is not to be limited to the details given herein. For example, the various elements or components may be combined or integrated in another system or certain features may be omitted, or not implemented.

Also, techniques, systems, subsystems and methods described and illustrated in the various embodiments as discrete or separate may be combined or integrated with other systems, modules, techniques, or methods without departing from the scope of the present disclosure. Other items shown or discussed as coupled or directly coupled or communicating with each other may be indirectly coupled or communicating through some interface, device, or intermediate component, whether electrically, mechanically, or otherwise. Other examples of changes, substitutions, and alterations are ascertainable by one skilled in the art.

## Claims

1. A user equipment 'UE' (120), comprising:
at least one component configured to decode a tail-biting convolution code (TBCC) based on a wrap-around Viterbi decoder performing at least one iteration, wherein each iteration comprises calculating a plurality of paths, performing a first trace-back operation at the end of the iteration and, if the first traced back path is not a tail-biting path, performing subsequent trace-back operations until a trace-back convergence check 'TCC' condition fails or the subsequent traced backed path is a tail-biting path,
wherein the TCC condition fails if a starting state of a first traced back path among the calculated paths is not equal to a starting state of the subsequent traced back path.

2. A base station (110), comprising:
at least one component configured to decode a tail-biting convolution code 'TBCC' based on a wrap-around Viterbi decoder performing at least one iteration, wherein each iteration comprises calculating a plurality of paths, performing a first trace-back operation at the end of the iteration and, if the first traced back path is not a tail-biting path, performing subsequent trace-back operations until a trace-back convergence check 'TCC' condition fails or the subsequent traced backed path is a tail-biting path,
wherein the TCC condition fails if a starting state of a first traced back path among the calculated paths is not equal to a starting state of the subsequent traced back path.

3. A method based on a wrap-around Viberbi algorithm, implemented on a device, comprising:
receiving a tail-biting convolution code 'TBCC'; and
performing a plurality of iterations wherein each iteration comprises calculating a plurality of paths, performing a first trace-back operation (330) at the end of the iteration, and, if the first traced back path is not a tail-biting path (340), performing subsequent trace-back operations (350) until a trace-back convergence check 'TCC' condition fails (360) or the subsequent traced backed path is a tail-biting path (362),
wherein the TCC condition fails if a starting state of a first traced back path among the calculated paths is not equal to a starting state of the subsequent traced back path.

4. The UE (120) of claim 1 or method of claim 3, wherein the TBCC is received in a Physical Control Channel 'PDCCH'.

5. The UE (120) of claim 1 or base station (110) of claim 2, wherein the TCC condition is not used during a first iteration and only a first calculated path is tracedback during the first iteration.

6. The UE (120) of claim 1 or base station (110) of claim 2, wherein the calculated paths are ordered based on their corresponding calculated state metrics before tracing back the calculated paths.

7. The UE (120) of claim 6, wherein the first traced back path has the highest value state metric and the subsequent traced back path has a lower value state metric.

8. The UE (120) of claim 6, wherein the first traced back path has the lowest value state metric and the subsequent traced back path has a higher value state metric.

9. The UE (120) of claim 1 or base station (110) of claim 2, wherein the first traced back path is used to obtain a match to an original bit stream that corresponds to the input stream before encoding if the first traced back path is a tail-biting path.

10. The UE (120) of claim 1 or base station (110) of claim 2, wherein the subsequent traced back path is used to obtain a match to an original bit stream that corresponds to the input stream before encoding if the subsequent traced back path is a tail-biting path and the first traced back path is not a trail-biting path.

11. The UE (120) of claim 1 or base station of claim 2, wherein the first traced back path is used to obtain a match to an original bit stream that corresponds to the input stream before encoding if none of the calculated paths is a tail-biting path.

12. The method of claim 3 further comprising:
sorting the computed paths based on their corresponding calculated state metrics;
tracing back at least one of the computed paths in the sorted order until a tail-biting path is found, a TCC condition fails, or all the computed paths are traced back; and
using the tail-biting path or the first traced back path if the tail-biting path is not found to obtain a match to an original bit stream that corresponds to the input stream before encoding.

13. The method of claim 3, wherein the device is one of a user equipment 'UE' (120), a base station (110), or any network connectivity device.

14. A computer readable medium which stores computer readable instructions executable by a processor of a computing device to cause said device to perform the methods of any of claims 3, 4, 12 and 13.

## Patentansprüche

1. Eine Benutzereinrichtung (UE - user equipment) (120), die aufweist:
zumindest eine Komponente, die konfiguriert ist zum Decodieren eines Tail-Biting-Faltungscodes (TBCC - tail-biting convolution code) basierend auf einem Wrap-around-Viterbi-Decodierer, der zumindest eine Iteration durchführt, wobei jede Iteration aufweist ein Berechnen einer Vielzahl von Pfaden, Durchführen einer ersten Zurückverfolgen-Operation an dem Ende der Iteration und, wenn der erste zurückverfolgte Pfad kein Tail-Biting-Pfad ist, Durchführen nachfolgender Zurückverfolgen-Operationen, bis eine Zurückverfolgen-Konvergenzprüfung(TCC - trace-back convergence check)-Bedingung fehlschlägt oder der nachfolgende zurückverfolgte Pfad ein Tail-Biting-Pfad ist,
wobei die TCC-Bedingung fehlschlägt, wenn ein Anfangszustand eines ersten zurückverfolgten Pfads aus den berechneten Pfaden nicht gleich ist zu einem Anfangszustand des nachfolgenden zurückverfolgten Pfads.

2. Eine Basisstation (110), die aufweist:
zumindest eine Komponente, die konfiguriert zum Decodieren eines TailBiting-Faltungscodes (TBCC - tail-biting convolution code) basierend auf einem Wrap-around-Viterbi-Decodierer, der zumindest eine Iteration durchführt, wobei jede Iteration aufweist ein Berechnen einer Vielzahl von Pfaden, Durchführen einer ersten Zurückverfolgen-Operation an dem Ende der Iteration und, wenn der erste zurückverfolgte Pfad kein Tail-Biting-Pfad ist, Durchführen nachfolgender Zurückverfolgen-Operationen, bis eine Zurückverfolgen-Konvergenzprüfung(TCC - trace-back convergence check)-Bedingung fehlschlägt oder der nachfolgende zurückverfolgte Pfad ein Tail-Biting-Pfad ist,
wobei die TCC-Bedingung fehlschlägt, wenn ein Anfangszustand eines ersten zurückverfolgten Pfads aus den berechneten Pfaden nicht gleich ist zu einem Anfangszustand des nachfolgenden zurückverfolgten Pfads.

3. Ein Verfahren basierend auf einem Wrap-around-Viterbi-Algorithmus, implementiert auf einer Vorrichtung, das aufweist:
Empfangen eines Tail-Biting-Faltungscodes (TBCC - tail-biting convolution code); und
Durchführen einer Vielzahl von Iterationen, wobei jede Iteration aufweist ein Berechnen einer Vielzahl von Pfaden, Durchführen einer ersten Zurückverfolgen-Operation (330) an dem Ende der Iteration und, wenn der erste zurückverfolgte Pfad kein Tail-Biting-Pfad ist (340), Durchführen nachfolgender Zurückverfolgen-Operationen (350), bis eine Zurückverfolgen-Konvergenzprüfung(TCC - trace-back convergence check)-Bedingung fehlschlägt (360) oder der nachfolgende zurückverfolgte Pfad ein Tail-Biting-Pfad ist (362),
wobei die TCC-Bedingung fehlschlägt, wenn ein Anfangszustand eines ersten zurückverfolgten Pfads aus den berechneten Pfaden nicht gleich ist zu einem Anfangszustand des nachfolgenden zurückverfolgten Pfads.

4. Die UE (120) gemäß Anspruch 1 oder das Verfahren gemäß Anspruch 3, wobei der TBCC in einem physikalischen Steuerkanal (PDCCH - Physical Control Channel) empfangen wird.

5. Die UE (120) gemäß Anspruch 1 oder die Basisstation (110) gemäß Anspruch 2, wobei die TCC-Bedingung während einer ersten Iteration nicht verwendet wird und nur ein erster berechneter Pfad während der ersten Iteration zurückverfolgt wird.

6. Die UE (120) gemäß Anspruch 1 oder die Basisstation (110) gemäß Anspruch 2, wobei die berechneten Pfade basierend auf ihren entsprechenden berechneten Zustandsmetriken geordnet werden, bevor die berechneten Pfade zurückverfolgt werden.

7. Die UE (120) gemäß Anspruch 6, wobei der erste zurückverfolgte Pfad eine Zustandsmetrik mit dem höchsten Wert hat und der nachfolgende zurückverfolgte Pfad eine Zustandsmetrik mit niedrigerem Wert hat.

8. Die UE (120) gemäß Anspruch 6, wobei der erste zurückverfolgte Pfad die Zustandsmetrik mit niedrigstem Wert hat und der nachfolgende zurückverfolgte Pfad eine Zustandsmetrik mit höherem Wert hat.

9. Die UE (120) gemäß Anspruch 1 oder die Basisstation (110) gemäß Anspruch 2, wobei der erste zurückverfolgte Pfad verwendet wird, um eine Übereinstimmung mit einem ursprünglichen Bitstrom zu erlangen, der dem Eingangsstrom vor einer Codierung entspricht, wenn der erste zurückverfolgte Pfad ein Tail-Biting-Pfad ist.

10. Die UE (120) gemäß Anspruch 1 oder die Basisstation (110) gemäß Anspruch 2, wobei der nachfolgende zurückverfolgte Pfad verwendet wird, um eine Übereinstimmung mit einem ursprünglichen Bitstrom zu erlangen, der dem Eingangsstrom vor einer Codierung entspricht, wenn der nachfolgende zurückverfolgte Pfad ein Tail-Biting-Pfad ist oder der erste zurückverfolgte Pfad kein Tail-Biting-Pfad ist.

11. Die UE (120) gemäß Anspruch 1 oder die Basisstation gemäß Anspruch 2, wobei der erste zurückverfolgte Pfad verwendet wird, um eine Übereinstimmung mit einem ursprünglichen Bitstrom zu erlangen, der dem Eingangsstrom vor einer Codierung entspricht, wenn keiner der berechneten Pfade ein Tail-Biting-Pfad ist.

12. Das Verfahren gemäß Anspruch 3, das weiter aufweist:
Ordnen der berechneten Pfade basierend auf ihren entsprechenden berechneten Zustandsmetriken;
Zurückverfolgen zumindest eines der berechneten Pfade in der geordneten Reihenfolge, bis ein Tail-Biting-Pfad gefunden ist, eine TCC-Bedingung fehlschlägt, oder alle berechneten Pfade zurückverfolgt sind; und
Verwenden des Tail-Biting-Pfads oder des ersten zurückverfolgten Pfads, wenn der Tail-Biting-Pfad nicht gefunden wird, um eine Übereinstimmung mit einem ursprünglichen Bitstrom zu erlangen, der dem Eingangsstrom vor einer Codierung entspricht.

13. Das Verfahren gemäß Anspruch 3, wobei die Vorrichtung eine aus einer Benutzereinrichtung (UE - user equipment) (120), einer Basisstation (110) oder einer Netzwerkverbindungsvorrichtung ist.

14. Ein computerlesbares Medium, das computerlesbare Anweisungen speichert, die durch einen Prozessor einer Computervorrichtung ausführbar sind, um die Vorrichtung zu veranlassen, die Verfahren gemäß einem der Ansprüche 3, 4, 12 und 13 durchzuführen.

## Revendications

1. Equipement d'utilisateur 'UE' (120), comprenant :
au moins un composant configuré pour décoder un code de convolution cyclique (TBCC) sur la base d'un décodeur de Viterbi à bouclage exécutant au moins une itération, où chaque itération comprend le calcul d'une pluralité de chemins, l'exécution d'une première opération de remontée à la fin de l'itération et, si le premier chemin remonté n'est pas un chemin cyclique, l'exécution des opérations de remontée suivantes jusqu'à ce qu'une condition de vérification de convergence de remontée 'TCC' échoue, ou jusqu'à ce que le chemin remonté suivant soit un chemin cyclique,
dans lequel la condition TCC échoue si un état de départ d'un premier chemin remonté parmi les chemins calculés n'est pas égal à un état de départ du chemin remonté suivant.

2. Station de base (110), comprenant :
au moins un composant configuré pour décoder un code de convolution cyclique 'TBCC' sur la base d'un décodeur de Viterbi à bouclage exécutant au moins une itération, où chaque itération comprend le calcul d'une pluralité de chemins, l'exécution d'une première opération de remontée à la fin de l'itération et, si le premier chemin remonté n'est pas un chemin cyclique, l'exécution des opérations de remontée suivantes jusqu'à ce qu'une condition de vérification de convergence de remontée 'TCC' échoue, ou jusqu'à ce que le chemin remonté suivant soit un chemin cyclique,
dans laquelle la condition TCC échoue si un état de départ d'un premier chemin remonté parmi les chemins calculés n'est pas égal à un état de départ du chemin remonté suivant.

3. Procédé basé sur un algorithme de Viterbi à bouclage, mis en oeuvre sur un dispositif, comprenant :
la réception d'un code de convolution cyclique 'TBCC' ; et
l'exécution d'une pluralité d'itérations où chaque itération comprend le calcul d'une pluralité de chemins, l'exécution d'une première opération de remontée (330) à la fin de l'itération et, si le premier chemin remonté n'est pas un chemin cyclique (340), l'exécution des opérations de remontée suivantes (350) jusqu'à ce qu'une condition de vérification de convergence de remontée 'TCC' échoue (360), ou jusqu'à ce que le chemin remonté suivant soit un chemin cyclique (362),
dans lequel la condition TCC échoue si un état de départ d'un premier chemin remonté parmi les chemins calculés n'est pas égal à un état de départ du chemin remonté suivant.

4. UE (120) de la revendication 1 ou procédé de la revendication 3, où le TBCC est reçu dans un canal de commande physique 'PDCCH'.

5. UE (120) de la revendication 1 ou station de base (110) de la revendication 2, où la condition TCC n'est pas utilisée pendant une première itération et seulement un premier chemin calculé est remonté lors de la première itération.

6. UE (120) de la revendication 1 ou station de base (110) de la revendication 2, où les chemins calculés sont ordonnés en se basant sur leurs métriques d'état calculées correspondantes avant que les chemins calculés ne soient remontés.

7. UE (120) de la revendication 6, dans lequel le premier chemin remonté comporte la valeur de métrique d'état la plus élevée et le chemin remonté suivant comporte une valeur de métrique d'état inférieure.

8. UE (120) de la revendication 6, dans lequel le premier chemin remonté comporte la valeur de métrique d'état la plus basse et le chemin remonté suivant comporte une valeur de métrique d'état supérieure.

9. UE (120) de la revendication 1 ou station de base (110) de la revendication 2, où le premier chemin remonté est utilisé pour obtenir une concordance avec un flux binaire d'origine qui correspond au flux d'entrée avant le codage si le premier chemin remonté est un chemin cyclique.

10. UE (120) de la revendication 1 ou station de base (110) de la revendication 2, où le chemin remonté suivant est utilisé pour obtenir une concordance avec un flux binaire d'origine qui correspond au flux d'entrée avant le codage si le chemin remonté suivant est un chemin cyclique et le premier chemin remonté n'est pas un chemin cyclique.

11. UE (120) de la revendication 1 ou station de base de la revendication 2, où le premier chemin remonté est utilisé pour obtenir une concordance avec un flux binaire d'origine qui correspond au flux d'entrée avant le codage si aucun des chemins calculés n'est un chemin cyclique.

12. Procédé de la revendication 3 comprenant en outre le fait de :
trier les chemins calculés sur la base de leurs métriques d'état calculées correspondantes ;
remonter au moins l'un des chemins calculés dans l'ordre de tri jusqu'à ce qu'un chemin cyclique soit trouvé, une condition TCC échoue, ou tous les chemins calculés soient remontés ; et
utiliser le chemin cyclique ou le premier chemin remonté si le chemin cyclique n'est pas trouvé pour obtenir une concordance avec un flux binaire d'origine qui correspond au flux d'entrée avant le codage.

13. Procédé de la revendication 3, dans lequel le dispositif est l'un(e) parmi un équipement d'utilisateur `UE' (120), une station de base (110), ou un dispositif quelconque de connexion réseau.

14. Support lisible par ordinateur qui stocke des instructions lisibles par ordinateur pouvant être exécutées par un processeur d'un dispositif informatique pour amener ledit dispositif à exécuter les procédés de l'une des revendications 3, 4, 12 et 13.
